(19) Europäisches Patentamt
European Patent Office
Office européen des brevets

(11) **EP 3 107 104 B1**

(12) **FASCICULE DE BREVET EUROPEEN**

(45) Date de publication et mention de la délivrance du brevet:
**18.04.2018 Bulletin 2018/16**

(51) Int Cl.:
***G11C 13/00*** *(2006.01)*

(21) Numéro de dépôt: **16174755.5**

(22) Date de dépôt: **16.06.2016**

(54) **PROCEDE DE LECTURE D'UN DISPOSITIF MEMOIRE ELECTRONIQUE**

VERFAHREN ZUM LESEN EINER ELEKTRONISCHEN SPEICHERVORRICHTUNG

METHOD FOR READING AN ELECTRONIC MEMORY DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.06.2015 FR 1555469**

(43) Date de publication de la demande:
**21.12.2016 Bulletin 2016/51**

(73) Titulaire: **COMMISSARIAT À L'ÉNERGIE ATOMIQUE ET AUX ÉNERGIES ALTERNATIVES**
**75015 Paris (FR)**

(72) Inventeur: **CAGLI, Carlo**
**38000 GRENOBLE (FR)**

(74) Mandataire: **Cabinet Camus Lebkiri**
**25 rue de Maubeuge**
**75009 Paris (FR)**

(56) Documents cités:
**US-A1- 2008 165 595     US-A1- 2012 257 448**
**US-A1- 2014 293 674**

**Description**

## DOMAINE TECHNIQUE DE L'INVENTION

Le domaine technique de l'invention est celui de la microélectronique, et en particulier celui des dispositifs mémoires électroniques. La présente invention concerne un procédé de lecture d'un dispositif mémoire électronique, et en particulier d'un dispositif mémoire électronique de type mémoire vive résistive.

## ARRIERE-PLAN TECHNOLOGIQUE DE L'INVENTION

Une mémoire vive résistive présente deux états de résistance distincts :

- un état fortement résistif HRS (de l'anglais « High Résistance State »), appelé également état « OFF », et
- un état faiblement résistif LRS (de l'anglais « Low Résistance State »), appelé également état « ON ».

Une mémoire vive résistive comporte des première et seconde électrodes séparées par une zone active. Une mémoire vive résistive bascule de manière réversible de l'état OFF vers l'état ON par application d'une première tension seuil entre les première et seconde électrodes, et bascule de manière réversible de l'état ON vers l'état OFF par application d'une deuxième tension seuil entre les première et deuxième électrodes. Elle peut donc être utilisée pour stocker une information binaire.

Les mémoires vives résistives présentent notamment les avantages suivants :

- faibles tensions seuils requises pour basculer d'un état à l'autre ;
- grande endurance ;
- faibles coûts de fabrication.

Un inconvénient majeur des mémoires vives résistives est toutefois la grande dispersion des résistances obtenues autour d'une résistance moyenne, d'un dispositif mémoire à l'autre, pour un même état résistif. La valeur de résistance d'un même état résistif peut ainsi varier de plus d'un ordre de grandeur, d'un dispositif mémoire à l'autre. Cet inconvénient est particulièrement critique pour l'état OFF des mémoires vives résistives. Le document WO 2014/137943 A2 décrit une méthode de détection des états résistifs de mémoires résistives au moyen d'un amplificateur de détection. L'amplificateur de détection permet de comparer les valeurs d'impédance de plusieurs mémoires, entre elles ou par rapport à une référence fixe. La méthode décrite par le document WO 2014/137943 A2 permet donc d'évaluer la dispersion des valeurs d'impédance d'un état résistif, mais ne permet pas de diminuer cette dispersion. Le document US-2014-293674 décrit décrit un procédé de lecture de deux cellules mémoires résistives ayant pour résistances respectives R1 et R2 et stockant un seul état logique, incluant: une étape d'association d'une valeur de résistance (Rm1= U/iRead1 et Rm2=U/iRead2) à chaque résistance pour l'obtention d'une combinaison particulière de deux valeurs de résistance, une étape d'application d'une fonction mathématique à la combinaison particulière des deux valeurs de résistance pour l'obtention d'une valeur de résistance résultante et une étape de détermination de l'état logique du dispositif mémoire électronique en fonction du résultat de comparaison de la valeur de résistance résultante avec une valeur de résistance seuil. Ce document stipule que les deux courants iRead1 et iRead2 peuvent être mesurés, stockés puis finalement additionnés via un circuit logique, ce qui implique que les courants sont digitalisés. Ceci permet de définir par avance un ensemble de valeurs de courant, et donc un ensemble de valeurs de résistance possibles pour chacune des deux cellules.

## RESUME DE L'INVENTION

Chaque dispositif mémoire d'un ensemble de dispositifs mémoires a, pour un état résistif donné, une certaine valeur de résistance. Un objectif de l'invention est de diminuer la dispersion des valeurs de résistance obtenues pour un même état résistif, au sein d'un ensemble de dispositifs mémoires électroniques.

Un aspect de l'invention concerne ainsi un procédé de lecture tel que défini par la revendication 1. Grâce à l'invention, le dispositif mémoire électronique comporte une pluralité de cellules mémoires de type mémoire vive résistive, et la pluralité de cellules mémoires de type mémoire vive résistive est avantageusement utilisée pour déterminer l'état logique du dispositif mémoire électronique. L'application d'une fonction mathématique à une combinaison particulière de N valeurs de résistance permet l'obtention d'une valeur de résistance résultante ayant une dispersion réduite par rapport à l'état de la technique.

Outre les caractéristiques qui viennent d'être évoquées dans le paragraphe précédent, le procédé de lecture d'un dispositif mémoire électronique selon un aspect de l'invention peut présenter une ou plusieurs caractéristiques complémentaires parmi les suivantes, considérées individuellement ou selon toutes les combinaisons techniquement possibles :

- La fonction mathématique appliquée est la fonction de moyenne géométrique. Alternativement, la fonction mathématique appliquée est la fonction de moyenne arithmétique.

- Chaque cellule mémoire Ci de la pluralité N de cellules mémoires est une mémoire vive résistive à base d'oxyde. Alternativement, chaque cellule mémoire Ci de la pluralité N de cellules mémoires est une mémoire vive résistive à pont conducteur.

- Le procédé de lecture selon le mode de réalisation de l'invention comporte, dans l'ordre :

  ◦ pour chaque résistance Ri, une étape de détermination d'un ensemble Ei de valeurs de résistance susceptibles d'être associées à ladite résistance Ri ;
  ◦ pour chaque combinaison de N variables Vi, chaque variable Vi prenant successivement chaque valeur de résistance parmi l'ensemble Ei prédéterminé, l'étape d'application de la fonction mathématique à ladite combinaison pour l'obtention d'une valeur de résistance résultante ;
  ◦ une étape d'association d'un état logique du dispositif mémoire électronique à chaque valeur de résistance résultante précédemment obtenue, en fonction d'une comparaison de chaque valeur de résistance résultante avec une valeur de résistance seuil ;
  ◦ l'étape d'association d'une valeur de résistance à chaque résistance Ri pour l'obtention d'une combinaison particulière de N valeurs de résistance ;
  ◦ l'étape de détermination de l'état logique du dispositif mémoire électronique, l'état logique étant associé à la valeur de résistance résultante correspondant à la combinaison particulière.

- Selon ce mode de réalisation, chaque valeur de résistance est associée à un code binaire, et chaque valeur de résistance résultante est associée à un code binaire résultant.

- Selon l'un quelconque des modes de réalisation, l'étape d'association d'une valeur de résistance à chaque résistance Ri est réalisée en utilisant au moins un comparateur.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1 montre schématiquement un dispositif mémoire électronique comportant une pluralité de cellules mémoires de type mémoire vive résistive.
- La figure 2 montre un diagramme des étapes d'un procédé de lecture d'un dispositif mémoire électronique.
- La figure 3 montre schématiquement un exemple de réalisation du procédé de lecture d'un dispositif mémoire électronique.

- La figure 4 montre schématiquement un exemple de réalisation d'une étape d'association d'une valeur de résistance à une résistance d'une cellule mémoire de type mémoire vive résistive.
- La figure 5 montre un diagramme des étapes d'un procédé de lecture d'un dispositif mémoire électronique selon un mode de réalisation de l'invention.
- La figure 6a montre un premier tableau, pour la réalisation d'une étape d'application d'une fonction mathématique, selon ce mode de réalisation de l'invention.
- La figure 6b montre un deuxième tableau rassemblant les valeurs de résistance résultante obtenues par l'application d'une première fonction mathématique, selon ce mode de réalisation de l'invention.

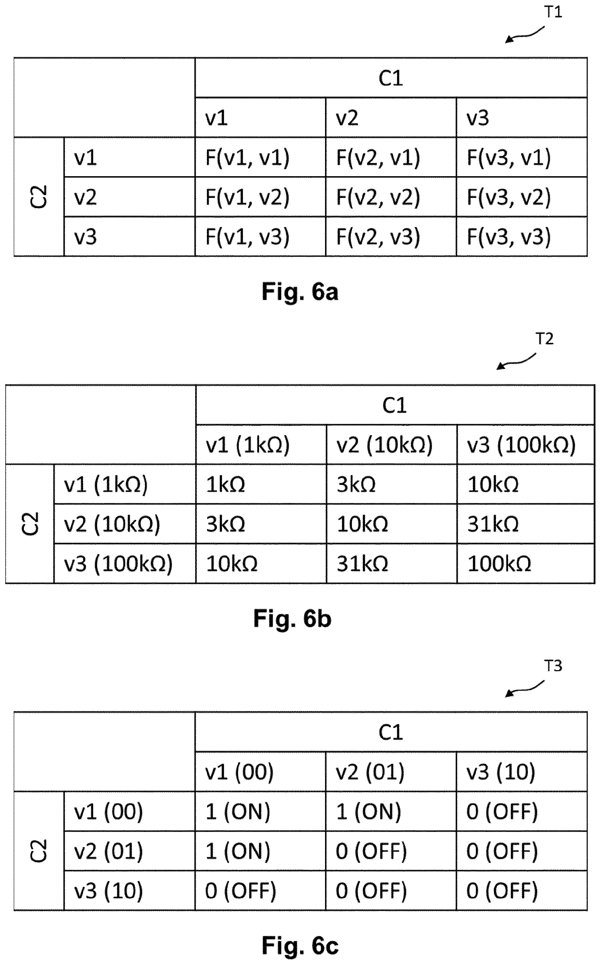

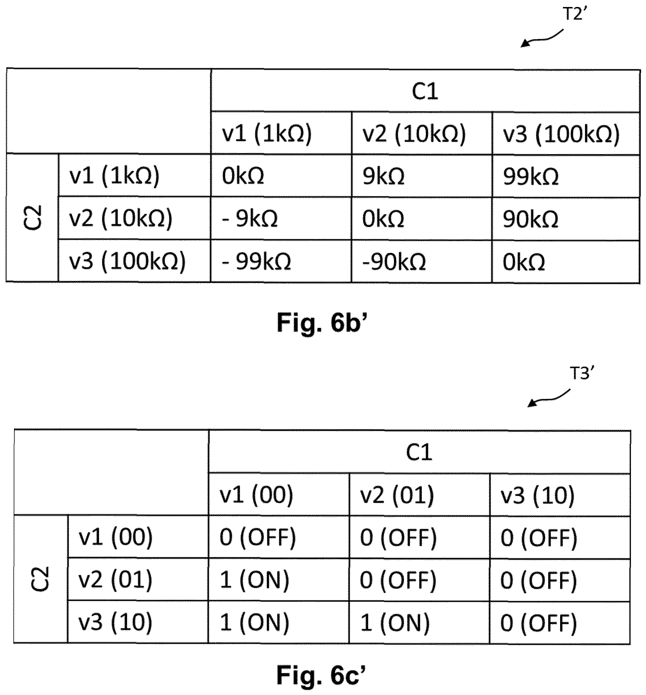

- La figure 6b' montre un deuxième tableau rassemblant les valeurs de résistance résultante obtenues par l'application d'une deuxième fonction mathématique, selon ce mode de réalisation de l'invention.
- La figure 6c montre un troisième tableau rassemblant les états logiques associés aux valeurs de résistances résultantes de la figure 6b, selon ce mode de réalisation de l'invention.
- La figure 6c' montre un troisième tableau rassemblant les états logiques associés aux valeurs de résistances résultantes de la figure 6b', selon ce mode de réalisation de l'invention.

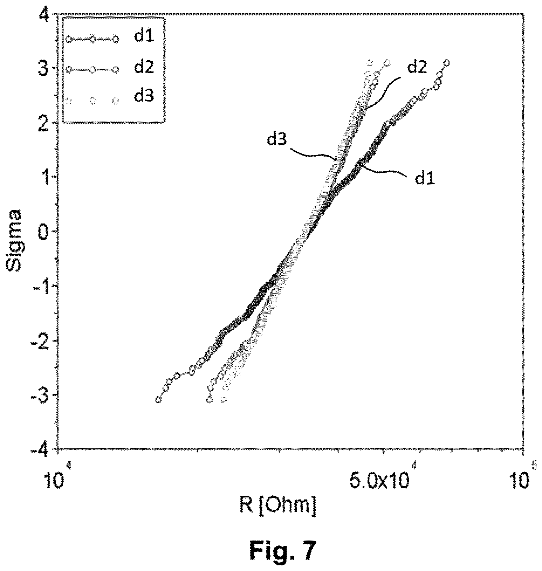

- La figure 7 montre schématiquement :

  ◦ une première distribution des valeurs de résistances obtenues pour un même état résistif d'un dispositif mémoire électronique, suivant un procédé de lecture de l'art antérieur ;
  ◦ une deuxième distribution des valeurs de résistances obtenues pour un même état résistif d'un dispositif mémoire électronique, suivant un procédé de lecture selon un mode de réalisation de l'invention ;
  ◦ une troisième distribution des valeurs de résistances obtenues pour un même état résistif d'un dispositif mémoire électronique, suivant un procédé de lecture selon un mode de réalisation de l'invention.

## DESCRIPTION DETAILLEE D'AU MOINS UN MODE DE REALISATION DE L'INVENTION

Sauf précision contraire, un même élément apparaissant sur des figures différentes présente une référence unique.

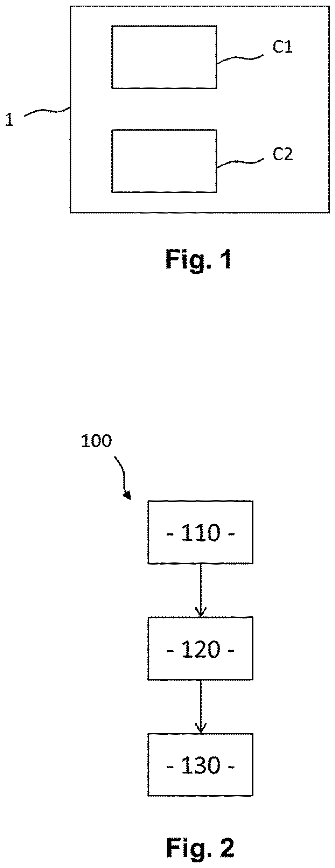

La figure 1 montre schématiquement un dispositif mémoire électronique 1 comportant une pluralité de cellules mémoires de type mémoire vive résistive Ci, avec i variant de 1 à N, N étant un entier naturel supérieur ou égal à 2. Chaque cellule mémoire Ci présente une résistance Ri.

L'exemple particulier de la figure 1 correspond au cas où N = 2 et le dispositif mémoire électronique 1 comporte ainsi :

- une première cellule mémoire C1 de type mémoire vive résistive, la première cellule mémoire C1 ayant une première résistance R1, et
- une deuxième cellule mémoire C2 de type mémoire vive résistive, la deuxième cellule mémoire C2 ayant une deuxième résistance R2.

Le domaine de la présente invention concerne plus particulièrement deux catégories de mémoires résistives :

- les mémoires vives résistives à base d'oxyde OxRRAM, comportant une zone active basée sur un matériau actif à base d'oxyde, et
- les mémoires vives résistives à pont conducteur CBRAM, comportant une zone active basée sur un matériau à conduction ionique, la zone active formant un électrolyte solide à conduction ionique disposé entre une électrode formant une cathode inerte et une électrode formant une anode soluble.

Ainsi, chaque cellule mémoire Ci de la pluralité N de cellules mémoires du dispositif mémoire électronique 1 est avantageusement une mémoire vive résistive à base d'oxyde OxRRAM, ou alternativement une mémoire vive résistive à pont conducteur CBRAM.

La figure 2 montre un diagramme des étapes d'un procédé 100 de lecture d'un dispositif mémoire électronique.
La figure 2 montre ainsi :

- une étape 110 selon laquelle une valeur de résistance est associée à chaque résistance Ri de chaque cellule mémoire Ci du dispositif mémoire électronique 1, pour l'obtention d'une combinaison particulière de N valeurs de résistance. Chaque valeur de résistance peut avantageusement être représentée par un code binaire.
- A l'issue de l'étape 110 précédemment décrite, une étape 120 selon laquelle une fonction mathématique est appliquée à la combinaison particulière de N valeurs de résistance, pour l'obtention d'une valeur de résistance résultante. La valeur de résistance résultante peut avantageusement être représentée par un code binaire résultant.
- A l'issue de l'étape 120 précédemment décrite, une étape 130 selon laquelle l'état logique du dispositif mémoire électronique 1 est déterminé.

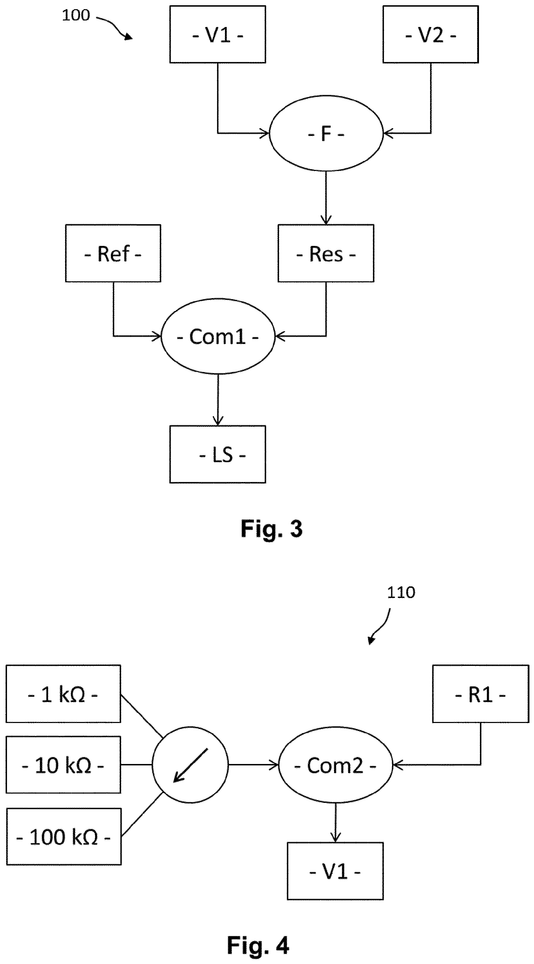

La figure 3 montre schématiquement un exemple de réalisation du procédé 100 de lecture d'un dispositif mémoire électronique. La première cellule mémoire C1 du dispositif mémoire électronique 1 est lue afin d'associer une première valeur de résistance V1 à la première résistance R1 de la première cellule mémoire C1. De même, la deuxième cellule mémoire C2 du dispositif mémoire électronique 1 est lue afin d'associer une deuxième valeur de résistance V2 à la deuxième résistance R2 de la deuxième cellule mémoire C2.
Une méthode et un dispositif de lecture d'une cellule mémoire d'un dispositif mémoire électronique sont ultérieurement décrits, en lien avec la figure 4.

Une fonction mathématique, référencée « F » sur la figure 3, est ensuite appliquée à la première valeur de résistance V1 et à la deuxième valeur de résistance V2. Le résultat de l'application de la fonction mathématique F aux première et deuxième valeurs de résistance V1 et V2 est une valeur de résistance résultante, référencée « Res » sur la figure 3 :

$$F\,(V1, V2) = Res$$

La valeur de résistance résultante Res est alors comparée, par exemple au moyen d'un comparateur référencé « Com1 » sur la figure 3, avec une valeur de résistance seuil, référencée « Ref » sur la figure 3. La valeur de résistance seuil Ref est typiquement prédéfinie. L'état logique du dispositif mémoire électronique 1 est alors déterminé en fonction du résultat de la comparaison de la valeur de résistance résultante Res avec la valeur de résistance seuil Ref. L'état logique du dispositif mémoire électronique 1 est référencé « LS » sur la figure 3. Par exemple :

- si Res > Ref, le dispositif mémoire électronique 1 est dans l'état OFF,
- si Res ≤ Ref, le dispositif mémoire électronique 1 est dans l'état ON.

La fonction mathématique F est avantageusement une fonction de moyenne géométrique. La fonction mathématique F appliquée à une combinaison particulière de N valeurs de résistance s'exprime ainsi :

$$F(V_1, V_2, \ldots, V_N) = (V_1 \times V_2 \times \ldots \times V_N)^{1/N}$$

La fonction mathématique F peut alternativement être une fonction de moyenne arithmétique. La fonction mathématique F appliqué à une combinaison particulière de N valeurs de résistance s'exprime alors :

$$F(V_1, V_2, \ldots, V_N) = \frac{(V_1 + V_2 + \cdots + V_N)}{N}$$

En utilisant une fonction mathématique telle qu'une moyenne géométrique ou arithmétique, on réduit la distribution des valeurs de résistance résultante obtenues pour un même état résistif. Afin de pouvoir correctement distinguer les deux états résistifs ON et OFF, il reste nécessaire que la distribution obtenue pour l'état résistif ON soit distincte et séparée de la distribution obtenue pour l'état résistif OFF.

Dans le cas particulier où le dispositif mémoire électronique 1 comporte seulement la première cellule mémoire C1 et la deuxième cellule mémoire C2, et où les première et deuxième cellules mémoires C1 et C2 sont programmées de manière complémentaire, la fonction mathématique F peut avantageusement être une fonction de soustraction. On entend par « programmation complémentaire » le fait que si la première cellule mémoire C1 est dans l'état OFF alors la deuxième cellule mémoire C2 est dans l'état ON, et inversement que si la première cellule mémoire C1 est dans l'état ON alors la deuxième cellule mémoire C2 est dans l'état OFF. La fonction mathématique F appliquée à une combinaison particulière de deux valeurs de résistance s'exprime alors :

$$F(V_1, V_2) = V_1 - V_2$$

Quand les première et deuxième cellules mémoires C1 et C2 sont programmées de manière complémentaire et que la fonction mathématique F est une fonction de soustraction, il n'est plus nécessaire que la distribution obtenue pour l'état résistif ON soit distincte et séparée de la distribution obtenue pour l'état résistif OFF : il suffit en effet que les première et deuxième cellules mémoires C1 et C2 aient des valeurs de résistance distinctes.

La figure 4 montre schématiquement un exemple de réalisation de l'étape 110 d'association d'une valeur de résistance à une résistance d'une cellule mémoire de type mémoire vive résistive. Un comparateur Com2 compare la première résistance R1 de la première cellule mémoire C1 avec plusieurs résistances prédéfinies, de valeur connue. Dans l'exemple particulier représenté à la figure 4, le comparateur Com2 compare la première résistance R1 avec trois résistances prédéfinies :

- une première résistance prédéfinie de valeur 1 kΩ,
- une deuxième résistance prédéfinie de valeur 10 kΩ, et
- une troisième résistance prédéfinie de valeur 100 kΩ.

Le comparateur Com2 peut naturellement comporter seulement deux résistances prédéfinies, ou plus de trois résistances prédéfinies. Les valeurs des résistances prédéfinies peuvent naturellement être choisies différemment par rapport à l'exemple particulier cité.

Le comparateur Com2 associe à la première résistance R1 une première valeur V1, qui est la valeur de résistance prédéfinie la plus proche de la valeur réelle de la première résistance R1. Dans l'exemple particulier représenté à la figure 4, si la première résistance R1 a une résistance réelle de 6kΩ ou 12 kΩ, le comparateur Com2 lui associe la première valeur V1 = 10 kΩ, c'est-à-dire la valeur de la deuxième résistance prédéfinie. Si la première résistance R1 a une résistance réelle de 55 kΩ, 78 kΩ ou 110 kΩ, le comparateur Com2 lui associe la première valeur V1 = 100 kΩ, c'est-à-dire la valeur de la troisième résistance prédéfinie.

Le comparateur Com2 peut également être utilisé pour associer à la deuxième résistance R2 de la deuxième cellule mémoire C2 une deuxième valeur V2. Alternativement, un autre comparateur que le comparateur Com2 peut être utilisé pour associer à la deuxième résistance R2 de la deuxième cellule mémoire C2 une deuxième valeur V2. Cet autre comparateur peut comporter le même nombre de résistances prédéfinies que le comparateur Com2, ou un nombre différent de résistances prédéfinies par rapport au comparateur Com2. Si cet autre comparateur comporte le même nombre de résistances prédéfinies que le comparateur Com2, les valeurs des résistances prédéfinies de l'autre comparateur peuvent être identiques aux valeurs des résistances prédéfinies du comparateur Com2, ou différentes des valeurs de résistances prédéfinies du comparateur Com2.

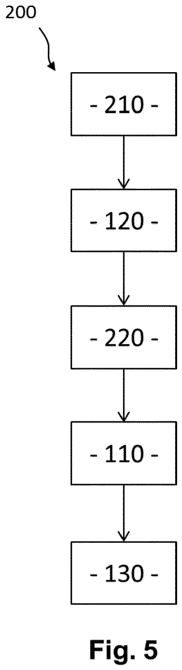

La figure 5 montre un diagramme des étapes d'un procédé 200 de lecture d'un dispositif mémoire électronique selon un mode de réalisation de l'invention. La figure 5 montre une étape 210 selon laquelle, pour chaque résistance Ri de chaque cellule mémoire Ci, un ensemble Ei de valeurs de résistances susceptibles d'être associées à ladite résistance Ri est déterminé. Dans l'exemple particulier du dispositif mémoire électronique 1 :

- un premier ensemble E1 de valeurs distinctes de résistance susceptibles d'être associées à la première résistance R1 de la première cellule mémoire C1 est déterminé, et
- un deuxième ensemble E2 de valeurs distinctes de résistance susceptibles d'être associées à la deuxième résistance R2 de la deuxième cellule mémoire C2 est déterminé.

Le premier ensemble E1 comporte par exemple trois valeurs de résistance susceptibles d'être associées à la première résistance R1 : une première valeur v1, une deuxième valeur v2 distincte de la première valeur v1 et une troisième valeur v3 distincte des première et deuxième valeurs v1 et v2. Le deuxième ensemble E2 est par exemple identique au premier ensemble E1. Alternativement, le deuxième ensemble E2 peut comporter un nombre différent de valeurs de résistance et/ou des valeurs de résistance différentes par rapport au premier ensemble E1.

A l'issue de l'étape 210, l'étape 120 d'application d'une fonction mathématique à une combinaison particulière de N valeurs de résistance, précédemment décrite, est réalisée pour chaque combinaison de N variables Vi, chaque variable Vi prenant successivement chaque valeur de résistance parmi l'ensemble Ei prédéterminé.

Dans l'exemple particulier du dispositif mémoire électronique 1 :

- le premier ensemble E1 comportant les première, deuxième et troisième valeurs de résistance v1, v2 et v3 a été déterminé pour la première résistance R1 de la première cellule mémoire C1, et
- le deuxième ensemble E2, identique au premier ensemble E1, a été déterminé pour la deuxième résistance R2 de la deuxième cellule mémoire C2.

La fonction mathématique F est donc appliquée aux neuf combinaisons de deux variables (V1, V2), où la première valeur V1 de la première résistance R1 prend successivement les valeurs v1, v2 et v3 du premier ensemble E1, et où la deuxième valeur V2 de la deuxième résistance R2 prend successivement les valeurs v1, v2 et v3 du deuxième ensemble E2.

Un premier tableau T1, représenté à la figure 6a, montre l'application de la fonction mathématique F auxdites neuf combinaisons.

Un deuxième tableau T2, représenté à la figure 6b, montre le résultat de l'application de la fonction mathématique F auxdites neuf combinaisons, dans le cas particulier où :

- la première valeur de résistance v1 vaut 1 k$\Omega$, la deuxième valeur de résistance v2 vaut 10 k$\Omega$ et la troisième valeur de résistance v3 vaut 100 k$\Omega$ ;
- la fonction mathématique F est la fonction de moyenne géométrique.

Le deuxième tableau T2 rassemble donc les neuf valeurs de résistance résultante obtenues par l'application de la fonction mathématique F de moyenne géométrique auxdites neuf combinaisons. Les neuf valeurs de résistance résultante dans le deuxième tableau T2 sont arrondies par troncature au k$\Omega$.

Un tableau T2' selon un autre exemple, représenté à la figure 6b', montre le résultat de l'application de la fonction mathématique F auxdites neuf combinaisons, dans le cas particulier où :

- la première valeur de résistance v1 vaut 1 k$\Omega$, la deuxième valeur de résistance v2 vaut 10 k$\Omega$ et la troisième valeur de résistance v3 vaut k$\Omega$ ;
- la fonction mathématique F est la fonction de soustraction.

Le tableau alternatif T2' selon cet autre exemple rassemble donc les neuf valeurs de résistance résultante obtenues par l'application de la fonction mathématique F de soustraction auxdites neuf combinaisons.

A l'issue de l'étape 120, une étape 220 est réalisée selon laquelle un état logique du dispositif mémoire électronique est associé à chaque valeur de résistance résultante précédemment obtenue, en fonction d'une comparaison de chaque valeur de résistance résultante avec une valeur de résistance seuil.

Un troisième tableau T3, représenté à la figure 6c, montre un exemple de résultat de l'association d'un état logique du dispositif mémoire électronique 1 à chacune des neuf valeurs de résistance résultante du deuxième tableau T2, dans le cas particulier où :

- la valeur de résistance seuil vaut 10 k$\Omega$,
- le dispositif mémoire électronique 1 est dans l'état OFF, ou « 0 », lorsque sa valeur de résistance résultante est supérieure ou égale à la valeur de résistance seuil, c'est-à-dire à 10 k$\Omega$,
- le dispositif mémoire électronique 1 est dans l'état ON, ou « 1 », lorsque sa valeur de résistance résultante est inférieure à la valeur de résistance seuil, c'est-à-dire à 10 k$\Omega$.

Un tableau T3' selon un autre exemple, représenté à la figure 6c', montre le résultat de l'association d'un état logique du dispositif mémoire électronique 1 à chacune des neuf valeurs de résistance résultante du tableau T2', dans le cas particulier où :

- la valeur de résistance seuil vaut 0 k$\Omega$,
- le dispositif mémoire électronique 1 est dans l'état OFF, ou « 0 », lorsque sa valeur de résistance résultante est supérieure ou égale à la valeur de résistance seuil, c'est-à-dire à 0 k$\Omega$,
- le dispositif mémoire électronique 1 est dans l'état ON, ou « 1 », lorsque sa valeur de résistance résultante est inférieure à la valeur de résistance seuil, c'est-à-dire à 0 k$\Omega$.

Dans les exemples particuliers des tableaux T3 et T3', un code binaire est associé à chaque valeur de résistance du premier ensemble E1 et du deuxième ensemble E2 :

- le code binaire « 00 » est associé à la première valeur de résistance v1,
- le code binaire « 01 » est associé à la deuxième valeur de résistance v2, et
- le code binaire « 10 » est associé à la troisième valeur de résistance v3.

A l'issue de l'étape 220, l'étape 110 d'association d'une valeur de résistance à chaque résistance Ri, précédemment décrite, est réalisée. L'exemple de réalisation de l'étape 110, précédemment décrit en lien avec la figure 4, peut être utilisé.

Le résultat de l'étape 110 peut par exemple être le suivant, dans le cas du dispositif mémoire électronique 1 :

- la première résistance R1 a une première valeur V1 = 10 k$\Omega$,
- la deuxième résistance R2 a une deuxième valeur V2 = 100 kΩ.

A l'issue de l'étape 110, l'étape 130 de détermination de l'état logique du dispositif mémoire électronique est réalisée. Selon ce mode de réalisation, l'état logique est prédéterminé par la valeur de la résistance résultante. La valeur de la résistance résultante a été précédemment calculée lors de l'étape 120, et un état logique a été précédemment associé à cette valeur de résistance résultante lors de l'étape 220. Dans l'exemple particulier où la fonction mathématique est la fonction de moyenne géométrique, pour la première valeur V1 =10 kΩ et la deuxième valeur V2 = 100 kΩ, la valeur de la résistance résultante vaut 31 kΩ. L'état associé à cette valeur de résistance résultante est l'état OFF. Dans l'autre exemple particulier où la fonction mathématique est la fonction de soustraction, pour la première valeur V1 = 10 kΩ et la deuxième valeur V2 = 100 kΩ, la valeur de résistance résultante vaut -90 kΩ. L'état associé à cette valeur de résistance résultante est l'état ON.

La figure 7 montre :

- une première distribution d1 des valeurs de résistances obtenues pour un même état résistif d'un dispositif mémoire électronique, suivant un procédé de lecture de l'art antérieur ;
- une deuxième distribution d2 des valeurs de résistances obtenues pour un même état résistif d'un dispositif mémoire électronique, suivant un procédé de lecture 200 selon un mode de réalisation de l'invention ;
- une troisième distribution d3 des valeurs de résistances obtenues pour un même état résistif d'un dispositif mémoire électronique, suivant un procédé de lecture 200 selon un mode de réalisation de l'invention.

Les première, deuxième et troisième distributions d1, d2 et d3 ont été mesurées pour environ 10 000 états résistifs. La deuxième distribution d2 est obtenue pour un dispositif mémoire électronique comportant deux cellules mémoires électroniques. La troisième distribution d3 est obtenue pour un dispositif mémoire électronique comportant trois cellules mémoires électroniques. La figure 7 montre que les deuxième et troisième distributions d2 et d3 ont une dispersion inférieure à la première distribution d1.

**Revendications**

1. Procédé (200) de lecture d'un dispositif mémoire électronique (1) comportant une pluralité N de cellules mémoires de type mémoire vive résistive Ci (C1, C2) avec i variant de 1 à N et N ≥ 2, chaque cellule mémoire Ci ayant une résistance Ri, le procédé comportant dans l'ordre les étapes suivantes :

- pour chaque cellule mémoire Ci, une étape (210) de détermination d'un ensemble Ei de valeurs de résistance (v1, v2, v3) susceptibles d'être associées à la résistance Ri de la cellule mémoire Ci ;
- pour chaque combinaison de N variables Vi, chaque variable Vi prenant successivement chaque valeur de résistance parmi l'ensemble Ei prédéterminé, une étape (120) d'application d'une fonction mathématique (F) à ladite combinaison pour l'obtention d'une valeur de résistance résultante (Res) ;
- pour chaque combinaison de N variables Vi, une étape (220) d'association d'un état logique du dispositif mémoire électronique à la valeur de résistance résultante correspondante précédemment obtenue, en fonction d'une comparaison de la valeur de résistance résultante correspondante avec une même valeur de résistance seuil ;
- une étape (110) d'association d'une valeur de résistance (V1, V2) à chaque résistance Ri pour l'obtention d'une combinaison particulière de N variables Vi ;
- une étape (130) de détermination de l'état logique du dispositif mémoire électronique (1), l'état logique étant associé à la valeur de résistance résultante correspondant à la combinaison particulière.

2. Procédé (200) de lecture selon la revendication précédente **caractérisé en ce que** la fonction mathématique (F) appliquée est la fonction de moyenne géométrique.

3. Procédé (200) de lecture selon l'une quelconque des revendications précédentes **caractérisé en ce que** chaque cellule mémoire Ci de la pluralité N de cellules mémoires est une mémoire vive résistive à base d'oxyde.

4. Procédé (200) de lecture selon l'une quelconque des revendications 1 ou 2 **caractérisé en ce que** chaque cellule mémoire Ci de la pluralité N de cellules mémoires est une mémoire vive résistive à pont conducteur.

5. Procédé (200) de lecture selon l'une quelconque des revendications précédentes **caractérisé en ce que** chaque valeur de résistance (V1, V2) est associée à un code binaire, et **en ce que** chaque valeur de résistance résultante (Res) est associée à un code binaire résultant.

6. Procédé (200) de lecture selon l'une quelconque des revendications précédentes **caractérisé en ce que** l'étape (110) d'association d'une valeur de résistance (V1, V2) à chaque résistance Ri est réalisée en utilisant au moins un comparateur (Com2).

## Patentansprüche

**1.** Leseverfahren (200) einer elektronischen Speichervorrichtung (1), umfassend eine Vielzahl N von Speicherzellen vom Typ resistiver Arbeitsspeicher Ci (C1, C2) mit i die von 1 bis N und N ≥ 2 variieren, wobei jede Speicherzelle Ci einen Widerstand Ri hat, wobei das Verfahren in der Reihenfolge die folgenden Schritte umfasst:

- für jede Speicherzelle Ci einen Bestimmungsschritt (201) einer Gruppe Ei von Widerstandswerten (v1, v2, v3), die geeignet sind, dem Widerstand Ri der Speicherzelle Ci zugeordnet zu werden;
- für jede Kombination von N Variablen Ni, jede Variable Vi, die sukzessive jeden Widerstandswert aus der vorbestimmten Gruppe Ei nimmt, einen Anwendungsschritt (120) einer mathematischen Funktion (F) auf die genannte Kombination für den Erhalt eines resultierenden Widerstandswertes (Res);
- für jede Kombination von N Variablen Vi einen Zuordnungsschritt (220) eines logischen Zustandes der elektronischen Speichervorrichtung zu dem entsprechenden, zuvor erhaltenen resultierenden Widerstandswert in Abhängigkeit von einem Vergleich des dem entsprechenden resultierenden Widerstandswert mit einem und demselben Schwellen-Widerstandswert;
- einen Zuordnungsschritt (110) eines Widerstandswertes (V1, V2) zu jedem Widerstand Ri für den Erhalt einer besonderen Kombination von N Variablen Vi;
- einen Bestimmungsschritt (130) des logischen Zustandes der elektronischen Speichervorrichtung (1), wobei der logische Zustand dem der besonderen Kombination entsprechenden resultierenden Widerstandswert entspricht.

**2.** Leseverfahren (200) gemäß dem voranstehenden Anspruch, **dadurch gekennzeichnet, dass** die angewendete mathematische Funktion (F) die geometrische Durchschnittsfunktion ist.

**3.** Leseverfahren (200) gemäß irgendeinem der voranstehenden Ansprüche, **dadurch gekennzeichnet, dass** jede Speicherzelle Ci der Vielzahl N von Speicherzellen ein resistiver Arbeitsspeicher auf Sauerstoffbasis ist.

**4.** Leseverfahren (200) gemäß irgendeinem der Ansprüche 1 oder 2, **dadurch gekennzeichnet, dass** jede Speicherzelle Ci der Vielzahl N von Speicherzellen ein resistiver Arbeitsspeicher mit Leiterbrücke ist.

**5.** Leseverfahren (200) gemäß irgendeinem der voranstehenden Ansprüche, **dadurch gekennzeichnet, dass** jeder Widerstandswert (V1, V2) einem binären Code zugeordnet ist und dass jeder resultierende Widerstandswert (Res) einem resultierenden binären Code zugeordnet ist.

**6.** Leseverfahren (200) gemäß irgendeinem der voranstehenden Ansprüche, **dadurch gekennzeichnet, dass** der Zuordnungsschritt (110) eines Widerstandswertes (V1, V2) zu jedem Widerstand R1 unter Verwendung wenigstens eines Komparators (Com2) realisiert ist.

## Claims

**1.** Method (200) for reading an electronic memory device (1) comprising a plurality N of memory cells of resistive random access memory type Ci (C1, C2) with i varying from 1 to N and N ≥ 2, each memory cell Ci having a resistance Ri, the method comprising in order the following steps:

- for each memory cell Ci, a step (210) of determining a set Ei of resistance values (v1, v2, v3) capable of being associated with the resistance Ri of the memory cell Ci;
- for each combination of N variables Vi, each variable Vi taking successively each resistance value among the predetermined set Ei, a step (120) of applying a mathematical function (F) to said combination to obtain a resulting resistance value (Res);
- for each combination of N variables Vi, a step (220) of associating a logic state of the electronic memory device with the corresponding resulting resistance value obtained previously, according to a comparison of the corresponding resulting resistance value with a same threshold resistance value;
- a step (110) of associating a resistance value (V1, V2) with each resistance Ri to obtain a particular combination of N variables Vi;
- a step (130) of determining the logic state of the electronic memory device (1), the logic state being associated with the resulting resistance value corresponding to the particular combination.

**2.** Reading method (200) according to the preceding claim **characterised in that** the mathematical function (F) applied is the geometric mean function.

**3.** Reading method (200) according to any of the preceding claims **characterised in that** each memory cell Ci of the plurality N of memory cells is an oxide based resistive random access memory.

4. Reading method (200) according to any of claims 1 or 2 **characterised in that** each memory cell Ci of the plurality N of memory cells is a conductive bridge resistive random access memory.

5. Reading method (200) according to any of the preceding claims **characterised in that** each resistance value (V1, V2) is associated with a binary code, and **in that** each resulting resistance value (Res) is associated with a resulting binary code.

6. Reading method (200) according to any of the preceding claims **characterised in that** the step (110) of associating a resistance value (V1, V2) with each resistance Ri is carried out using at least one comparator (Com2).

C1

C2

1

**Fig. 1**

100

- 110 -

- 120 -

- 130 -

**Fig. 2**

100

- V1 -

- V2 -

- F -

- Ref -

- Res -

- Com1 -

- LS -

**Fig. 3**

110

- 1 kΩ -

- 10 kΩ -

- 100 kΩ -

- R1 -

- Com2 -

- V1 -

**Fig. 4**

200

```
        ┌──────────┐
        │  - 210 - │
        └────┬─────┘
             │
             ▼
        ┌──────────┐
        │  - 120 - │
        └────┬─────┘
             │
             ▼
        ┌──────────┐
        │  - 220 - │
        └────┬─────┘
             │
             ▼
        ┌──────────┐
        │  - 110 - │
        └────┬─────┘
             │
             ▼
        ┌──────────┐
        │  - 130 - │
        └──────────┘
```

**Fig. 5**

T1

| | | C1 | | |
|---|---|---|---|---|
| | | v1 | v2 | v3 |
| C2 | v1 | F(v1, v1) | F(v2, v1) | F(v3, v1) |
| | v2 | F(v1, v2) | F(v2, v2) | F(v3, v2) |
| | v3 | F(v1, v3) | F(v2, v3) | F(v3, v3) |

**Fig. 6a**

T2

| | | C1 | | |
|---|---|---|---|---|
| | | v1 (1kΩ) | v2 (10kΩ) | v3 (100kΩ) |
| C2 | v1 (1kΩ) | 1kΩ | 3kΩ | 10kΩ |
| | v2 (10kΩ) | 3kΩ | 10kΩ | 31kΩ |
| | v3 (100kΩ) | 10kΩ | 31kΩ | 100kΩ |

**Fig. 6b**

T3

| | | C1 | | |
|---|---|---|---|---|
| | | v1 (00) | v2 (01) | v3 (10) |
| C2 | v1 (00) | 1 (ON) | 1 (ON) | 0 (OFF) |
| | v2 (01) | 1 (ON) | 0 (OFF) | 0 (OFF) |
| | v3 (10) | 0 (OFF) | 0 (OFF) | 0 (OFF) |

**Fig. 6c**

T2'

| | | C1 | | |
|---|---|---|---|---|
| | | v1 (1kΩ) | v2 (10kΩ) | v3 (100kΩ) |
| C2 | v1 (1kΩ) | 0kΩ | 9kΩ | 99kΩ |
| | v2 (10kΩ) | - 9kΩ | 0kΩ | 90kΩ |
| | v3 (100kΩ) | - 99kΩ | -90kΩ | 0kΩ |

## Fig. 6b'

T3'

| | | C1 | | |
|---|---|---|---|---|
| | | v1 (00) | v2 (01) | v3 (10) |
| C2 | v1 (00) | 0 (OFF) | 0 (OFF) | 0 (OFF) |
| | v2 (01) | 1 (ON) | 0 (OFF) | 0 (OFF) |
| | v3 (10) | 1 (ON) | 1 (ON) | 0 (OFF) |

## Fig. 6c'

Fig. 7

**EP 3 107 104 B1**

## RÉFÉRENCES CITÉES DANS LA DESCRIPTION

**Documents brevets cités dans la description**

- WO 2014137943 A2

- US 2014293674 A